# EUROPEAN PATENT APPLICATION

(11) **EP 2 511 925 A2**
(43) Date of publication of application: **17.10.2012**
(21) Application number: 12162505.7
(22) Date of filing: 30.03.2012
(51) Int. Cl.: H01G 9/20

(54) **Dye-sensitized solar cell, and seal member to be used for the dye-sensitized solar cell**

(30) Priority: 15.04.2011 JP 2011090846
(71) Applicant: Nitto Denko Corporation, Osaka 567-8680 (JP)
(72) Inventor: Igarashi, Kazumasa, Osaka, 567-8680 (JP); Hasegawa, Yuki, Osaka, 567-8680 (JP); Yoshida, Naoko, Osaka, 567-8680 (JP); Yamada, Yasumi, Osaka, 567-8680 (JP); Sasa, Kazuaki, Osaka, 567-8680 (JP)
(74) Representative: HOFFMANN EITLE

(57) **Abstract**

A dye-sensitized solar cell of a polymer resin type is provided, which is excellent in sealability. A counter electrode substrate (1) provided with an electrically conductive transparent electrode layer (5) and a working electrode substrate (1') provided with an electrically conductive transparent electrode layer (5') are opposed to each other with the electrode layers (5, 5') facing inward. A space defined between the substrates (1, 1') is sealed with a seal member (4) disposed along peripheries of inner surfaces of the substrates (1, 1'). An electrolyte solution is filled in the sealed space. The substrates (1, 1') are each made of a polymer resin material. Inorganic layers (2, 2' , 3, 3') are provided between the substrates (1, 1') and the electrode layers (5, 5'). The seal member (4) is composed of a material obtained by curing a photopolymerizable composition essentially comprising a specific hydrogenated elastomer derivative. The inorganic layers (3,3') each have a portion coated with a (meth)acryloxyalkylsilane silage coupling agent in contact with the seal member (4).

## Description

### BACKGROUND OF THE INVENTION

### 1. Field of the Invention

The present invention relates to a dye-sensitized solar cell of a polymer resin (plastic film) substrate type which includes a pair of electrode substrates adhesively sealed in opposed relation, and an electrolyte solution filled in a space defined between the electrode substrates. More specifically, the invention relates to a dye-sensitized solar cell including a seal member which is highly resistant to the electrolyte solution and excellent in adhesive sealability and durability, and to a seal member to be used for the dye-sensitized solar cell.

### 2. Description of the Related Art

A dye-sensitized solar cell which includes an electrically conductive transparent substrate formed with a dye-carrying porous semiconductor layer such as of titanium oxide (TiO₂), a counter electrode substrate and a redox-type electrolyte solution filled in a space defined between these substrates is promising as a less expensive next-generation solar cell because of its higher solar light conversion efficiency.

However, if a conventionally used ethylene-methacrylic acid copolymer ionomer resin is used as a sealing material for a dye-sensitized solar cell including a redox-type electrolyte solution such as of iodine or lithium iodide filled in a space defined between polymer resin (plastic film) substrates, it is impossible to prevent leakage of the electrolyte solution and absorption of external moisture. Therefore, the dye-sensitized solar cell of this type is poor in durability. Therefore, formation of a gas barrier layer is proposed for suppression of intrusion of moisture, oxygen and the like in the electrolyte solution layer (see JP-A-2005-142086 and JP-A-2009-140828).

However, a sealing method and a seal member which provide satisfactory durability for prevention of leakage of the electrolyte solution are not proposed. On the other hand, epoxy resin sealing materials, urethane resin sealing materials and photo-curable acryl resin sealing materials conventionally known to be used as liquid crystal sealing materials are liable to swell with the electrolyte solution due to their polar structures. This adversely affects the structure of the dye-sensitized solar cell.

In view of this, it is proposed that a liquid epoxy resin or a silicone resin is used for sealing the electrolyte solution (see JP-A-2000-30767). Further, a sealing material containing a silane coupling agent and prepared by polymerizing an organo-hydrogen polysiloxane and a polyisoprene polymer having at least one alkenyl group in its molecule to be subjected to a hydrosilylation reaction in the presence of a hydrosilylation catalyst is proposed as a sealing material containing an elastomer more excellent in electrolyte solution resistance for the dye-sensitized solar cell (see JP-A-2004-95248).

However, the sealing material (seal member) disclosed in JP-A-2000-30767 suffers from swelling or degradation of the resin with the electrolyte solution during prolonged sealing use, and has unsatisfactory properties. The sealing material disclosed in JP-A-2004-95248 requires heating to 80°C to 150°C for curing. The heating evaporates the electrolyte solution, leading to separation of the seal member. This results in leakage of the electrolyte solution.

Further, the dye-sensitized solar cell simply including the polymer resin (plastic film) substrates has unsatisfactory durability under temperature and humidity load conditions in environment and endurance tests specified in JIS C8938 which presupposes outdoor installation (a temperature cycle test A-1 performed in a temperature range between -40°C and 90°C in 200 cycles, a temperature/humidity cycle test A-2 performed in a temperature range between -40°C and 85°C at 85 %RH in 10 cycles, a heat resistance test B-1 performed at 85°C for 1000 hours, and a moisture resistance test B-2 performed at 85°C at 85 %RH for 1000 hours).

This is supposedly because the adhesion between the seal member and the polymer resin (plastic film) substrates in the dye-sensitized solar cell is insufficient without any treatment of the polymer resin substrates. Even if the polymer resin substrates are surface-treated with a silane coupling agent of a (meth)acryloxyalkylsilane, interaction between portions of the polymer resin of the polymer resin substrates in contact with the seal member and the (meth)acryloxyalkylsilane silane coupling agent is insufficient, resulting in insufficient adhesion between the seal member and the polymer resin substrates.

Further, if the polymer resin substrates are used in the dye-sensitized solar cell without any treatment thereof, moisture permeation through the entire surfaces of the polymer resin substrates cannot be suppressed below the intrinsic moisture permeability level of the plastic film. Therefore, the removal of the dye from the porous semiconductor layer and the deterioration of the electrolyte solution are liable to occur due to the moisture absorption of the electrolyte solution during prolonged storage. As a result, the dye-sensitized solar cell is liable to have deteriorated performance (e.g., lower conversion efficiency) and insufficient durability.

### SUMMARY OF THE INVENTION

A dye-sensitized solar cell is provided including a counter electrode substrate and a working electrode substrate each formed of a polymer resin material, and a seal member free from the swelling and the degradation during prolonged sealing use and highly excellent in sealability, and to provide a seal member to be used for the dye-sensitized solar cell.

According to a first aspect, there is provided a dye-sensitized solar cell, which includes: a pair of substrates including a counter electrode substrate provided with a counter electrode layer and a working electrode substrate provided with an electrically conductive transparent working electrode layer, the substrates being opposed to each other and spaced a predetermined distance from each other with the counter electrode layer and the working electrode layer facing inward; a seal member disposed along peripheries of inner surfaces of the substrates to seal a space defined between the substrates; and an electrolyte solution filled in the sealed space; wherein the substrates are each made of a polymer resin material; wherein inorganic layers are provided between the counter electrode substrate and the counter electrode layer and between the working electrode substrate and the working electrode layer; wherein the seal member is composed of a material cured by photopolymerizing a photopolymerizable composition comprising a hydrogenated elastomer derivative having at at least one (meth)acryloyl group at least one of its opposite molecular terminals; wherein the inorganic layers each have a portion coated with a silane coupling agent of a (meth)acryloxyalkylsilane in contact with the seal member.

According to a second aspect, there is provided a dye-sensitized solar cell seal member to be disposed along peripheries of inner surfaces of paired substrates disposed in opposed relation in the dye-sensitized solar cell, wherein the seal member is composed of a material cured by photopolymerizing a photopolymerizable composition comprising a hydrogenated elastomer derivative having at least one (meth)acryloyl group at at least one of its opposite molecular terminals.

The inventors conducted studies to provide sealing that is excellent in electrolyte solution resistance and adhesiveness and highly durable in a dye-sensitized solar cell including substrates of a polymer resin material. Photopolymerizable resin compositions containing a photopolymerizable resin as an effective component are useful as a sealing material. Specific ones of the photopolymerizable compositions are particularly effective as the sealing material. In addition, forming inorganic layers on surface portions of the polymer resin substrates to be sealed with the seal member or to be brought into contact with the seal member (or to coat the surface portions of the polymer resin substrates with the inorganic layers) result in effective sealing, further, coating surface portions of the inorganic layers to be brought into contact with the seal member on the substrate with a silane coupling agent of a (meth)acryloxyalkylsilane result in effective sealing.

That is, the inventors conducted intensive studies on a seal member of the dye-sensitized solar cell produced by employing the polymer resin substrates rather than glass substrates or metal substrates as electrode substrates. If the inorganic layers are provided on the surfaces of the polymer resin substrates, the seal member and the specific surface coating are also useful for the polymer resin substrates.

In the dye-sensitized solar cell including the counter electrode substrate and the working electrode substrate both made of the polymer resin material (a plastic film or the like), the seal member is composed of the material cured by photopolymerizing the photopolymerizable composition comprising the hydrogenated elastomer derivative having at at least one (meth)acryloyl group at least one of its opposite molecular terminals, and the inorganic layers are provided on the surface portions of the substrates in contact with the seal member. Further, the portions of the inorganic layers to be brought into contact with the seal member are coated with the silane coupling agent of the (meth)acryloxyalkylsilane. That is, thermal curing is unnecessary because the seal member is composed of the material cured by the photopolymerization, so that the separation of the seal member is prevented which may otherwise occur due to the evaporation of the electrolyte solution caused by the heating. The cured material for the seal member is formed from the specific photopolymerizable composition and, therefore, is free from the swelling and the degradation with the electrolyte solution during prolonged sealing use. In addition, the synergetic effect of the aforementioned specific silane coupling agent on the inorganic layers provided on the surfaces of the substrates ensures higher adhesiveness and higher durability.

The silane coupling agent is the (meth)acryloxyalkylsilane silane coupling agent. With the use of the silane coupling agent, photopolymerizable (meth)acryloyl groups are present on the inorganic layers (surface coating layers) on the polymer resin substrates, and undergo the photopolymerization reaction together with the (meth)acryloyl groups in the photopolymerizable composition to provide strong adhesiveness.

Since the inorganic layers have a gas barrier property, it is possible to prevent moisture absorption through the entire surfaces of the polymer resin substrates during long-term storage. Therefore, the dye-sensitized solar cell is substantially free from any inconvenience attributable to moisture, and highly reliable with excellent durability.

Where the inorganic layers each include not less than two inorganic layers provided in a layered structure and/or the inorganic layers are layers each made of a specific silicon-containing material, the inorganic layers are further excellent in gas barrier property. Further, the inorganic layers are highly reactive with the (meth)acryloxyalkylsilane silane coupling agent, so that the silane coupling agent is effectively fixed to the inorganic layers.

Where the photopolymerizable composition contains at least one of a phyllosilicate and an insulative spherical inorganic filler, the seal member has a reduced moisture permeability. Therefore, the seal member is further excellent in durability with lower moisture permeation through the seal member from the atmosphere during prolonged sealing use. Further, the seal member has a seal width having an improved dimensional accuracy because the photopolymerizable composition has greater thixotropy.

Where 3-(meth)acryloxypropyltrimethoxysilane is used as the silane coupling agent, the seal member has further excellent adhesiveness.

Where the hydrogenated elastomer derivative contains one of a hydrogenated polybutadiene and a hydrogenated polyisoprene in its main chain, the nonpolar structure of the main chain improves the durability against the electrolyte solution.

Where the hydrogenated elastomer derivative is one of a hydrogenated polybutadiene derivative and a hydrogenated polyisoprene derivative obtained through a reaction between a hydroxy (meth) acrylate compound and a corresponding one of a hydrogenated polybutadiene polyol and a hydrogenated polyisoprene polyol by using a polyisocyanate as a linking group, the seal member and a coating protective member are further excellent in adhesiveness and durability.

Where the hydrogenated elastomer derivative is one of a hydrogenated polybutadiene derivative and a hydrogenated polyisoprene derivative obtained through a reaction between a (meth)acryloyl-containing isocyanate compound and a corresponding one of a hydrogenated polybutadiene polyol and a hydrogenated polyisoprene polyol, the seal member and the coating protective member are further excellent in adhesiveness and durability as in the aforementioned case.

Where the photopolymerizable composition contains a poly(meth)acrylate compound in addition to the hydrogenated elastomer derivative, the crosslinking density of the material for the seal member is increased. Therefore, the seal member is further excellent in durability and, when a photopolymerization initiator is used, the curability with ultraviolet (UV) radiation is improved.

### BRIEF DESCRIPTION OF THE DRAWING

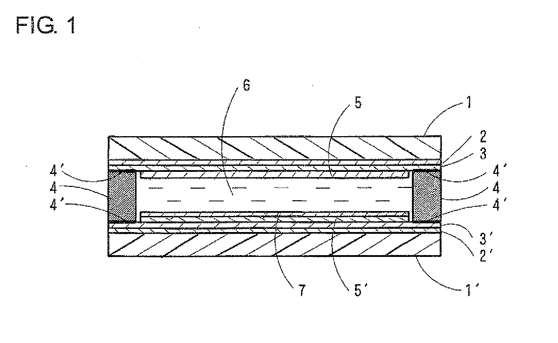

FIG. 1 is a sectional view illustrating an exemplary dye-sensitized solar cell.

### DETAILED DESCRIPTION OF THE INVENTION

An embodiment of the present invention will hereinafter be described.

A dye-sensitized solar cell has the following technical features. The dye-sensitized solar cell includes a pair of substrates each provided with an electrode layer, a seal member and an electrolyte solution filled in a closed space defined by the pair of substrates and the seal member; the substrates are each made of a polymer resin material; inorganic layers are respectively provided between the substrates and the electrode layers; the seal member is composed of a material cured by photopolymerizing a photopolymerizable composition comprising a hydrogenated elastomer derivative having at least one (meth)acryloyl group at at least one of its opposite molecular terminals; and the inorganic layers each have a portion coated with a silane coupling agent of a (meth)acryloxyalkylsilane in contact with the seal member. The (meth)acryloyl group means an acryloyl group and a corresponding methacryloyl group shown below:

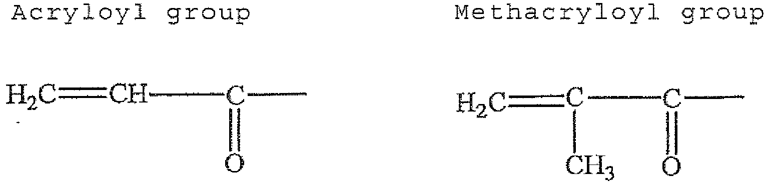

First, the dye-sensitized solar cell will be described.

### «Dye-Sensitized Solar Cell»

The dye-sensitized solar cell is typically configured as shown in FIG. 1. More specifically, the dye-sensitized solar cell includes a counter electrode substrate 1 provided with an electrically conductive transparent counter electrode layer 5, and a working electrode substrate 1' provided with an electrically conductive transparent working electrode layer 5'. The electrode substrates 1, 1' are opposed to each other and are spaced a predetermined distance from each other with the electrically conductive transparent electrode layers 5, 5' facing inward. A space defined between the substrates 1 and 1' is sealed with a seal member 4 (main seal) provided along peripheries of inner surfaces of the substrates 1, 1' and formed from a specific photopolymerizable composition, and an electrolyte solution 5 is filled in the sealed space. Inorganic layers 2, 3 and inorganic layers 2', 3' are provided in the form of double layered structures between the counter electrode substrate 1 and the electrically conductive transparent electrode layer 5 and between the working electrode substrate 1' and the electrically conductive transparent electrode layer 5, respectively. Portions of the inorganic layers 3, 3' (out of the inorganic layers 2, 2', 3, 3' provided in the form of double layered structures between the substrates 1, 1' and the electrically conductive transparent electrode layers 5, 5') to be brought into contact with the seal member 4 are each formed with a coating film 4' of a specific silane coupling agent ((meth)acryloxyalkylsilane coupling agent).

As shown in FIG. 1, the dye-sensitized solar cell typically includes a porous semiconductor layer 7 such as a titanium oxide film provided on the electrically conductive transparent electrode layer 5' on the working electrode substrate 1'. A sensitizing dye which is not shown is adsorbed and carried on the porous semiconductor layer 7.

The dye-sensitized solar cell will hereinafter be described based on FIG. 1. However, the invention is not limited to the dye-sensitized solar cell of FIG. 1. The components of the dye-sensitized solar cell will be individually described below.

### <Counter Electrode Substrate 1 and Working Electrode Substrate 1'>

The counter electrode substrate 1 and the working electrode substrate 1' are each made of a polymer resin material. At least the working electrode substrate 1' is required to be transparent. The term "transparent" generally means that a visible light transmittance is higher than 80%. The visible light transmittance is measured by a commercially available common visible light transmittance meter.

Transparent polymer films, for example, are usable as the substrates 1, 1'. Specific examples of the polymer resin material include polyethylenes (PE), polypropylenes (PP), polyesters, nylons, polyethylene terephthalates (PET), polyethylene naphthalates (PEN), polyvinyl chlorides, silicone resins and polyimides. <Electrically conductive transparent Electrode Layer 5 on Counter Electrode Substrate 1>

Exemplary materials for the electrically conductive transparent electrode layer 5 provided on the counter electrode substrate 1 include electrically conductive transparent electrode materials such as indium-doped tin oxide (ITO), fluorine-doped indium oxide (FIO), fluorine-doped tin oxide (FTO), indium-zinc oxide (IZO), indium-gallium-zinc oxide (IGZO) and zinc oxide, gold, platinum, carbon and electrically conductive polymers, which may be used either alone or in combination.

### <Electrically conductive transparent Electrode Layer 5' on Working Electrode Substrate 1'>

Exemplary materials for the electrically conductive transparent electrode layer 5' provided on the working electrode substrate 1' include electrically conductive transparent electrode materials such as indium-doped tin oxide (ITO), fluorine-doped indium oxide (FIO), fluorine-doped tin oxide (FTO), indium-zinc oxide (IZO), indium-gallium-zinc oxide (IGZO) and zinc oxide, which may be used either alone or in combination. A lower resistance ITO or a lower resistance FTO is preferably used, which has a smaller internal electrical resistance and a sheet resistance of 10 to 30 Ω/□.

### <Inorganic Layers 2, 2', 3, 3'>

The inorganic layers 2, 3 and the inorganic layers 2', 3' are provided in the form of double layered structures between the counter electrode substrate 1 and the electrically conductive transparent electrode layer 5 and between the working electrode substrate 1' and the electrically conductive transparent electrode layer 5', respectively. The inorganic layers, which have a gas barrier property, are preferably provided in the form of multilayer structures, e.g., at least double layered structures, as shown in FIG. 1.

The inorganic layers 2, 2', 3, 3' are each preferably a transparent inorganic layer made of at least one of an oxide, a nitride, an oxynitride, an oxycarbide, a nitrocarbide and an oxynitrocarbide of at least one element selected from the group consisting of Si, Al, In, Sn, Zn, Ti, Nb, Ce and Zr, more preferably at least one transparent inorganic layer selected from the group consisting of a silicon oxide layer, a silicon oxynitride layer, a silicon oxycarbide layer, a silicon oxycarbonitride layer and a silicon nitride layer, and may include other layer. The at least one transparent inorganic layer selected from the group consisting of the silicon oxide layer, the silicon oxynitride layer, the silicon oxycarbide layer, the silicon oxycarbonitride layer and the silicon nitride layer may have hydroxyl groups in its surface. It is particularly preferred that the outermost ones (the inorganic layers 3, 3' (adjacent to the electrode layers) in FIG. 1) of the inorganic layers provided on the counter electrode substrate 1 and the working electrode substrate 1' provided in opposed relation are silicon oxide layers. The silicon oxide layers are highly reactive with the (meth)acryloxyalkylsilane silane coupling agent to be used for the coating, so that the silane coupling agent is effectively fixed to the inorganic layers. The inorganic layers provided on the side of the substrates 1, 1' (the inorganic layers 2, 2' (adjacent to the substrates) in FIG. 1) are preferably silicon oxycarbonitride layers.

Since any of the aforementioned transparent inorganic layers are employed as the inorganic layers 3, 3', the portions of the inorganic layers 3, 3' to be brought into contact with the seal member 4 are uniformly coated with the(meth)acryloxyalkylsilane silane coupling agent. Therefore, the seal member 4 has higher adhesiveness to the substrates 1, 1' and is highly durable. More specifically, the seal member 4 has sufficient durability under temperature and humidity load conditions in environment and endurance tests specified in JIS C8938 which presupposes that the seal member is used with a glass substrate (a temperature cycle test A-1 performed in a temperature range between -40°C and 90°C in 200 cycles, a temperature/humidity cycle test A-2 performed in a temperature range between -40°C and 85°C at 85 %RH in 10 cycles, a heat resistance test B-1 performed at 85°C for 1000 hours, and a moisture resistance test B-2 performed at 85°C at 85 %RH for 1000 hours).

The total thickness of the inorganic layers, e.g., the total thickness of the inorganic layers provided in the form of double layered structure shown in FIG. 1 (the total thickness of the inorganic layer 2 and the inorganic layer 3 or the total thickness of the inorganic layer 2' and the inorganic layer 3'), is preferably 10 to 1000 nm, more preferably 50 to 500 nm for improvement in flexibility of the inorganic layers. If the total thickness is excessively small, it is difficult for the inorganic layers to exhibit a sufficient gas barrier property. If the total thickness is excessively great, the inorganic layers are liable to suffer from cracking to have a poorer gas barrier property.

Where the inorganic layers are provided in the form of double layered structures as shown in FIG. 1, the inorganic layers 3, 3' having a surface portion coated with the (meth)acryloxyalkylsilane silane coupling agent to be brought into contact with the seal member 4 are not required to have a gas barrier property. Therefore, the inorganic layers 3, 3' each preferably have the smallest possible thickness, which is preferably 5 to 100 nm, more preferably 20 to 50 nm. On the other hand, the inorganic layers 2, 2' located on the side of the substrates 1, 1' each preferably have a thickness of 10 to 1000 nm for the gas barrier property, more preferably 50 to 500 nm for improvement of the flexibility of the inorganic layers 2, 2'. If the thickness is excessively small, it is difficult to impart the inorganic layers with a sufficient gas barrier property. If the thickness is excessively great, the inorganic layers are each liable to suffer from cracking to have a poorer gas barrier property.

The inorganic layers 2, 2', 3, 3' may be formed by a known vacuum evaporation method to be performed at a pressure of not higher than 1 Pa, a sputtering method, a chemical vapor deposition (CVD) method or the like. By any of these methods, the inorganic layers can be densely formed on the substrates 1, 1' of the polymer resin material to be thereby imparted with a higher gas barrier property. In the evaporation method, a metal material or an inorganic material is evaporated by resistive heating or an electron beam to form a thin film. The formation of the thin film may be carried out in a gas atmosphere such as of oxygen or nitrogen. A very dense and transparent layer can be formed by the assist with an ion beam or a plasma beam (plasma assisted evaporation). In the sputtering method, a thin film is formed by sputtering particles of a metal material or an inorganic material employed as a target in an atmosphere of a noble gas such as argon by application of a higher voltage. In the CVD method, a thin film is formed by supplying a material gas such as an organic metal in vacuum. Particularly, where the material gas is supplied in a plasma atmosphere, a thin film can be densely formed.

Particularly, as shown in FIG. 1, the inorganic layers 2, 3 and the inorganic layers 2', 3' are provided in the form of double layered structures on the substrates 1, 1', respectively, and the inorganic layers 3, 3' to be surface-coated with the (meth)acryloxyalkylsilane silane coupling agent and brought into contact with the seal member 4 are preferably formed by the vacuum evaporation method, the sputtering method or the chemical vapor deposition (CVD) method described above. Particularly, thin oxide films are preferably formed as the inorganic layers 3, 3' in an oxygen gas atmosphere.

As shown in FIG. 1, the inorganic layers 2, 2' located on the side of the substrates 1, 1' in the double layered structures preferably include at least one layer selected from the group consisting of a silicon oxide layer, a silicon oxynitride layer, a silicon oxycarbide layer, a silicon oxycarbonitride layer and a silicon nitride layer, which have a gas barrier property against water vapor, oxygen gas and nitrogen gas. The silicon oxide layer, the silicon oxynitride layer, the silicon oxycarbide layer, the silicon oxycarbonitride layer and the silicon nitride layer may be formed either alone or in combination with other material layer.

The term "gas barrier property" is intended to encompass a moisture barrier property. More specifically, if a 200-nm thick silicon oxynitride layer formed on a surface of a biaxially stretched 100-to 120-µm thick PEN film has a moisture permeability of not greater than 0.05 g/m², for example, the silicon oxynitride layer has an extremely high barrier property.

### <Porous Semiconductor Layer 7>

Exemplary materials for the porous semiconductor layer 7 to be provided on the working electrode substrate 1' include porous metal oxide semiconductors such as titanium oxide, zinc oxide, tin oxide, indium oxide, zirconium oxide, silicon oxide, magnesium oxide, aluminum oxide, cesium oxide, bismuth oxide, manganese oxide, yttrium oxide, tungsten oxide, tantalum oxide, niobium oxide and lanthanum oxide. Particularly, titanium oxide and zinc oxide of an anatase type are preferred for higher conversion efficiency.

The porous semiconductor layer 7 is formed, for example, by dispersing titanium oxide particles each having a diameter of 50 to 200 nm in a known dispersion medium to prepare a sol solution, applying the sol solution on the electrically conductive transparent electrode layer 5' on the working electrode substrate 1' by means of a bar coater, and drying and firing the resulting sol solution film at a lower temperature which does not damage the polymer resin material (working electrode substrate 1') to be used. Where a PEN is used as the polymer resin material, more specifically, the formation of the porous semiconductor layer 7 may be carried out at a temperature of 100°C to 120°C.

The porous semiconductor layer 7 preferably has a thickness of 5 to 50 µm, more preferably 10 to 30 µm.

### <Sensitizing Dye>

The sensitizing dye to be adsorbed and carried on the porous semiconductor layer 7 is, for example, capable of injecting carriers into the porous semiconductor layer 7 after absorbing light. Preferred examples of the sensitizing dye include ruthenium complexes (N3 dye, N719 dye, N907 dye and the like), acridine dyes, azo dyes, indigo dyes, quinone dyes, coumarin dyes, merocyanine dyes and phenylxanthene dyes, among which the ruthenium complexes are preferred for higher conversion efficiency.

### <Electrolyte Solution 6>

The electrolyte solution 6 to be filled in the space defined between the substrates 1 and 1' is an electrolyte-containing liquid, and includes an electrolyte and a liquid medium. Various electrolytes are usable, but an electrolyte containing iodine and an iodide such as lithium iodide, potassium iodide, sodium iodide or calcium iodide in combination is preferably used. Examples of the liquid medium include acetonitrile, propionitrile, n-butyronitrile, 3-methoxypropionitrile, methoxyacetonitrile, valeronitrile, glutaronitrile, propylene carbonate, γ-butyrolactone and various ionic liquids. Gel electrolytes containing nano-particles and any of various crosslinked acrylates and additives may be used. Particularly, an electrolyte solution containing the nitrile solvent is preferably used for higher conversion efficiency.

### <Coating Films 4'>

As described above, the coating films 4' are formed on the portions of the inorganic layers 3, 3' provided on the substrates 1, 1' to be brought into contact with the seal member 4 by applying the silane coupling agent of the (meth)acryloxyalkylsilane. Examples of the (meth)acryloxyalkylsilane silane coupling agent include acryloxyalkylsilanes and methacryloxyalkylsilanes. Preferred examples of the (meth)acryloxyalkylsilane include 3-acryloxypropyltrimethoxysilane and 3-methacryloxypropyltrimethoxysilane, of which 3-acryloxypropyltrimethoxysilane having higher photopolymerization reactivity is more preferred. These (meth) acryloxyalkylsilane silane coupling agents may be used either alone or in combination.

### <Seal Member 4>

The seal member 4 provided between the inorganic layers 3 and 3' respectively provided on the substrates 1 and 1' is composed of the material cured by photopolymerizing the aforementioned photopolymerizable composition. The photopolymerizable composition contains the hydrogenated elastomer derivative. The hydrogenated elastomer derivative is not particularly limited as long as it has at least one (meth) acryloyl group at at least one of its opposite molecular terminals. The major chain of the hydrogenated elastomer derivative is preferably a hydrogenated polybutadiene or a hydrogenated polyisoprene.

Examples of the hydrogenated polybutadiene as the main chain of the hydrogenated elastomer derivative include hydrogenated 1, 4-polybutadienes, hydrogenated 1,2-polybutadienes, and copolymers and the like of hydrogenated 1,4-polybutadienes and hydrogenated 1,2-polybutadienes. Examples of the hydrogenated polyisoprene include hydrogenated 1,4-polyisoprenes, hydrogenated 1,2-polyisoprenes, and copolymers and the like of hydrogenated 1,4-polyisoprenes and hydrogenated 1,2-polyisoprenes.

More preferably, the hydrogenated elastomer derivative is a hydrogenated polybutadiene derivative (a1) or a hydrogenated polyisoprene derivative (a2) obtained through a reaction between a hydrogenated polybutadiene polyol and a hydroxy(meth)acrylate compound or between a hydrogenated polyisoprene polyol and the hydroxy(meth)acrylate compound by using a polyisocyanate as a linking group. Further, the hydrogenated elastomer derivative may be a hydrogenated polybutadiene derivative (a3) or a hydrogenated polyisoprene derivative (a4) obtained through a reaction between a hydrogenated polybutadiene polyol and a (meth) acryloyl-containing isocyanate compound or between a hydrogenated polyisoprene polyol and the (meth)acryloyl-containing isocyanate compound.

Components to be employed for synthesis of the hydrogenated polybutadiene derivative (a1) or the hydrogenated polyisoprene derivative (a2) through the reaction between the hydrogenated polybutadiene polyol and the hydroxy(meth)acrylate compound or between the hydrogenated polyisoprene polyol and the hydroxy(meth)acrylate compound by using the polyisocyanate as the linking group will be described.

The hydrogenated polybutadiene polyol and the hydrogenated polyisoprene polyol are preferably telechelic polymers each having reactive functional groups such as hydroxyl groups at opposite molecular terminals thereof. Examples of the hydrogenated polybutadiene polyol and the hydrogenated polyisoprene polyol include hydrogenated polybutadienes and hydrogenated polyisoprenes each having hydroxyl groups at opposite molecular terminals thereof.

The hydrogenated polybutadiene polyol is preferably a liquid hydrogenated polybutadiene polyol having a number average molecular weight of 500 to 5000, and the hydrogenated polyisoprene polyol is preferably a liquid hydrogenated polyisoprene polyol having a number average molecular weight of 500 to 130000.

Examples of the polyisocyanate serving as the linking group include hexamethylene diisocyanate, norbornene diisocyanate, isophorone diisocyanate, xylylene diisocyanate, hydrogenated xylylene diisocyanate, dicyclohexylmethane diisocyanate, tolylene diisocyanate, diphenylmethane diisocyanate and naphthalene diisocyanate, which may be used either alone or in combination. Particularly, saturated diisocyanates such as hexamethylene diisocyanate, norbornene diisocyanate, isophorone diisocyanate, hydrogenated xylylene diisocyanate and dicyclohexylmethane diisocyanate are preferably used.

Examples of the hydroxy(meth)acrylate compound include monofunctional hydroxy(meth)acrylate compounds such as 2-hydroxyethyl (meth)acrylate, 2-hydroxypropyl (meth)acrylate, 2-hydroxybutyl (meth)acrylate, 2-hydroxyethyl (meth)acryloyl phosphate, 4-hydroxybutyl (meth)acrylate and 2-(meth)acryloyloxyethyl-2-hydroxypropyl phthalate, difunctional hydroxy(meth)acrylate compounds such as glycerin di(meth)acrylate and trimethylolpropane di(meth)acrylate, and multifunctional hydroxy(meth)acrylate compounds such as 2-hydroxy-1,3-di(meth)acryloxypropane (glycerin di(meth)acrylate) and pentaerythritol tri(meth)acrylate, among which the multifunctional hydroxy(meth)acrylate compounds having two or more functional groups are preferred for improvement of the crosslinking density. The (meth)acrylate means an acrylate and a corresponding methacrylate.

For the synthesis, the proportions of the hydrogenated polybutadiene polyol or the hydrogenated polyisoprene polyol, the polyisocyanate and the hydroxy(meth)acrylate compound are as follows:

The polyisocyanate is preferably blended in a proportion of 2 to 10 equivalents, more preferably 4 to 8 equivalents, per hydroxyl equivalent (an average molecular weight per hydroxyl group) of the hydrogenated polybutadiene polyol or the hydrogenated polyisoprene polyol. If the equivalent proportion is excessively low, a higher molecular weight linear polymer is liable to be produced. If the equivalent proportion is excessively high, a greater number of unreacted isocyanate groups tend to remain.

The hydroxy(meth)acrylate compound is preferably blended in a proportion of 1 to 2 equivalents, more preferably 1.1 to 1.3 equivalents, per isocyanate equivalent (a molecular weight per isocyanate group) of the polyisocyanate. If the equivalent proportion is excessively low, isocyanate groups tend to remain. If the equivalent proportion is excessively high, a greater amount of the hydroxy(meth)acrylate compound tends to remain.

The hydrogenated polybutadiene derivative (a1) or the hydrogenated polyisoprene derivative (a2) is synthesized, for example, in the following manner. The hydrogenated polybutadiene polyol or the hydrogenated polyisoprene polyol is caused to react with the polyisocyanate in the presence of a catalyst of a metal such as titanium or tin or an organic metal salt such as dibutyltin laurate. After the hydroxyl groups of the hydrogenated polybutadiene polyol or the hydrogenated polyisoprene polyol sufficiently react with the isocyanate groups, the hydroxy(meth)acrylate compound is added for a reaction with the residual isocyanate groups. Thus, the hydrogenated elastomer derivative is provided. Where the resulting hydrogenated elastomer derivative is highly viscous or semi-solid, the hydrogenated elastomer derivative is heated to 30°C to 80°C, or a solvent such as toluene or xylene is added to the reaction system. Thus, the reaction smoothly proceeds, thereby facilitating the synthesis.

The degree of the synthesis reaction can be determined by measuring an infrared absorbance at a characteristic absorption band attributable to the isocyanate group (at about 2260 cm⁻¹) in an infrared absorption spectrum, because the absorbance at the characteristic absorption band attributable to the isocyanate group is reduced as the reaction proceeds. The completion of the synthesis reaction is determined based on the fact that the absorbance at the characteristic absorption band attributable to the isocyanate group is reduced to zero.

After the completion of the reaction, the reaction product is rinsed with a solvent such as acetonitrile for removal of a soluble component thereof, and then the solvent is removed in a known manner by means of an evaporator or the like. Thus, the hydrogenated elastomer derivative having at least one (meth) acryloyl group at at least one of its opposite molecular terminals is provided.

On the other hand, components to be employed for synthesis of the hydrogenated polybutadiene derivative (a3) or the hydrogenated polyisoprene derivative (a4) through the reaction between the hydrogenated polybutadiene polyol and the (meth)acryloyl-containing isocyanate compound or between the hydrogenated polyisoprene polyol and the (meth)acryloyl-containing isocyanate compound will be described.

The hydrogenated polybutadiene polyol and the hydrogenated polyisoprene polyol are preferably telechelic polymers each having reactive functional groups such as hydroxyl groups at opposite molecular terminals thereof. Examples of the hydrogenated polybutadiene polyol and the hydrogenated polyisoprene polyol include hydrogenated polybutadienes and hydrogenated polyisoprenes each having hydroxyl groups at opposite molecular terminals thereof.

The hydrogenated polybutadiene polyol is preferably a liquid hydrogenated polybutadiene polyol having a number average molecular weight of 500 to 5000, and the hydrogenated polyisoprene polyol is preferably a liquid hydrogenated polyisoprene polyol having a number average molecular weight of 500 to 130000.

Examples of the (meth)acryloyl-containing isocyanate compound include 2-(meth)acryloyloxyethyl isocyanate and 1,1-bis(acryloyloxymethyl) ethyl isocyanate.

For the synthesis, the proportions of the hydrogenated polybutadiene polyol or the hydrogenated polyisoprene polyol and the (meth)acryloyl-containing isocyanate compound are as follows:
The (meth)acryloyl-containing isocyanate compound is preferably blended in a proportion of 1 to 3 equivalents, more preferably 1.2 to 2 equivalents, per hydroxyl equivalent (an average molecular weight per hydroxyl group) of the hydrogenated polybutadiene polyol or the hydrogenated polyisoprene polyol. If the equivalent proportion is excessively low, unreacted hydroxyl groups tend to remain. If the equivalent proportion is excessively high, unreacted isocyanate groups tend to remain.
The hydrogenated polybutadiene derivative (a3) or the hydrogenated polyisoprene derivative (a4) is synthesized, for example, in the following manner. The hydrogenated polybutadiene polyol or the hydrogenated polyisoprene polyol is caused to react with the (meth)acryloyl-containing isocyanate compound in the presence of a catalyst of a metal such as titanium or tin or an organic metal salt such as dibutyltin laurate. The reaction between the hydroxyl groups of the hydrogenated polybutadiene polyol or the hydrogenated polyisoprene polyol and the isocyanate groups of the (meth)acryloyl-containing isocyanate compound provides the hydrogenated elastomer derivative. Where the resulting hydrogenated elastomer derivative is highly viscous or semi-solid, the hydrogenated elastomer derivative is heated to 30°C to 80°C, or a solvent such as toluene or xylene is added to the reaction system. Thus, the reaction smoothly proceeds, thereby facilitating the synthesis.

The degree of the synthesis reaction can be determined by measuring an infrared absorbance at a characteristic absorption band attributable to the isocyanate group (at about 2260 cm⁻¹) in an infrared absorption spectrum, because the absorbance at the characteristic absorption band attributable to the isocyanate group is reduced as the reaction proceeds. The completion of the synthesis reaction is determined based on the fact that the absorbance at the characteristic absorption band attributable to the isocyanate group is reduced to zero.

After the completion of the reaction, the reaction product is rinsed with a solvent such as acetonitrile for removal of a soluble component thereof, and then the solvent is removed in a known manner by means of an evaporator or the like. Thus, the hydrogenated elastomer derivative having at least one (meth) acryloyl group at at least one of its opposite molecular terminals is provided.

The proportion of the hydrogenated elastomer derivative is preferably 1 to 99 wt%, more preferably 10 to 90 wt%, based on the overall amount of the photopolymerizable composition.

The photopolymerizable composition to be used for the seal member 4 essentially contains any of the aforementioned various hydrogenated elastomer derivatives, and may contain a phyllosilicate and/or an insulative spherical inorganic filler as optional components. These optional components may be used either alone or in combination.

The phyllosilicate is a silicate mineral having interlaminar exchangeable cations, and may be a naturally occurring phyllosilicate or a synthesized phyllosilicate. The phyllosilicate is not particularly limited, but examples thereof include smectite clay minerals such as montmorillonite, saponite, hectorite, beidellite, stevensite and nontrolite, and swellable mica, vermiculite and halloysite, which may be used either alone or in combination. Particularly, at least one of swellable mica and lipophilic smectite each subjected to an organic treatment and having affinity for an organic solvent with their interlaminar Na ions exchanged with cations is preferably used.

The phyllosilicate is preferably in the form of crystalline particles having an average length of 0.005 to 10 µm and a thickness of 0.001 to 5 µm with an aspect ratio of 10 to 500.

The phyllosilicate is a laminar clay mineral having metal cations such as Na ions intercalated between its layers. A phyllosilicate organically treated with dimethyl distearyl ammonium chloride, chloroaminolauric acid, a quaternary ammonium salt or a quaternary phosphonium salt for ion exchange of the Na ions is preferably used. The organically treated phyllosilicate with its Na ions ion-exchanged has higher affinity for the resin and, therefore, can be easily dispersed in the resin by means of a high-speed shearing dispersing machine such as a three-roll mill or a ball mill.

Examples of the insulative spherical inorganic filler include silica powder, alumina powder, titanium oxide powder, calcium carbonate powder and calcium silicate powder, which may be used either alone or in combination. It is possible to design the insulative spherical inorganic filler in any desired manner to impart surfaces of the filler with a hydrophobic property or a hydrophilic property for dispersibility of the filler in the hydrogenated elastomer derivative. For easier improvement of the affinity for the resin component, the silica powder is preferably used, and fused spherical silica powder is particularly preferably used.

The insulative spherical inorganic filler preferably has an average particle diameter of 0.01 to 1 µm and a maximum particle diameter of not greater than 10 µm, more preferably an average particle diameter of 0.05 to 1 µm and a maximum particle diameter of not greater than 1 µm. If the average particle diameter is excessively small, the effect of reducing the moisture permeability of the cured material is insufficient with an excessively great specific surface area. If the average particle diameter is excessively great, the UV transmissive property of the seal member 4 is impaired, so that the photo-curability is unsatisfactory. If the maximum particle diameter is excessively great, the UV transmissive property is impaired, so that the photo-curability is unsatisfactory.

The average particle diameter and the maximum particle diameter are measured, for example, by means of a laser diffraction-scattering particle size distribution analyzer. The values of the average particle diameter and the maximum particle diameter are determined with the use of samples arbitrarily extracted from a population by means of the aforementioned analyzer.

The organically treated phyllosilicates out of the aforementioned phyllosilicates, and the insulative spherical inorganic fillers are preferably chemically surface-modified. This improves the affinity for the resin component such as the hydrogenated elastomer derivative, thereby reducing the viscosity of the uncured solution and improving the dispersibility of the phyllosilicate and the insulative spherical inorganic filler.

A compound to be used for the chemical modification is not particularly limited, as long as it is reactive with functional groups such as hydroxyl groups and carboxyl groups present in surfaces of the organically treated phyllosilicate and the insulative spherical inorganic filler. Preferred examples of such a compound include reactive silane compounds such as silane coupling agents and silylation agents, titanate compounds and isocyanate compounds, which may be used either alone or in combination.

The compound for the chemical modification is used in the same manner as in a conventionally known surface treatment of an inorganic filler, e.g., a surface treatment to be performed in an organic solvent.

Examples of the silane coupling agent include 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-triethoxysilyl-N-(1,3-dimethylbutylidene)propylamine, N-phenyl-3-aminopropyltriethoxysilane, a hydrochloric acid salt of N-(vinylbenzyl)-2-aminoethyl-3-aminopropyltrimethoxysilane, 3-ureidopropyltrimethoxysilane, 3-chloropropyltrimethoxysilane, 3-mercaptopropylmethyldimethoxysilane, 3-mercaptopropyltrimethoxysilane, bis(triethoxysilylpropyl) tetrasulfide and 3-isocyanatopropyltriethoxysilane, which may be used either alone or in combination.

Examples of the silylation agent include methyltrichlorosilane, methyldichlorosilane, dimethyldichlorosilane, trimethylchlorosilane, phenyltrichlorosilane, diphenyldichlorosilane, trifluoropropyltrichlorosilane and hexamethyldisilazane, which may be used either alone or in combination.

Examples of the titanate compound include tetraalkyl titanate compounds such as tetraisopropyl titanate and tetra-n-butyl titanate, and their lower molecular weight condensation products, which may be used either alone or in combination.

Examples of the isocyanate compound include (meth)acryloxyisocyanate compounds such as 2-isocyanatoethyl methacrylate, 2-isocyanatoethyl acrylate and 1,1-bis(acryloxymethyl) ethyl isocyanate, which may be used either alone or in combination.

The phyllosilicate is preferably present in the photopolymerizable composition in a proportion of 0.1 to 20 wit%, more preferably 1 to 10 wt%, based on the overall amount of the seal member 4. If the proportion is excessively low, the moisture permeability of the seal member 4 is insufficiently reduced. If the proportion is excessively high, the viscosity of the uncured liquid sealing material is extremely high, thereby causing a problem in a coating process.

The insulative spherical inorganic filler is preferably present in the photopolymerizable composition in a proportion of 30 to 70 wt%, more preferably 40 to 60 wt%, based on the overall amount of the seal member 4. If the proportion is excessively low, the moisture permeability of the seal member 4 is insufficiently reduced. If the proportion is excessively high, the viscosity of the uncured liquid sealing material is extremely high, thereby causing a problem in the coating process.

As required, the photopolymerizable composition may further contain a poly(meth)acrylate compound (b) and a photopolymerization initiator (c) as optional components.

The poly(meth)acrylate compound (b) serves as a diluent when the hydrogenated elastomer derivative is blended in the photopolymerizable composition, and serves as a crosslinking agent when the photopolymerizable composition is cured. Examples of the poly(meth)acrylate compound include multifunctional (meth)acrylates.

Examples of the multifunctional (meth)acrylates include difunctional (meth)acrylates such as 1,4-butanediol di(meth)acrylate, 1,6-hexanediol di(meth)acrylate, 1,9-nonanediol di(meth)acrylate, 1,10-decanediol di(meth)acrylate, 1,12-dodecanediol di(meth)acrylate, 1,12-octadecanediol di(meth)acrylate, 2-n-butyl-2-ethyl-1,3-propanediol di(meth)acrylate, tripropyleneglycol di(meth)acrylate, norbornene di(meth)acrylate and dimethyloldicyclopentane di(meth)acrylate (tricyclodecanedimethanol di(meth)acrylate), trifunctional (meth)acrylates such as trimethylolpropane tri(meth)acrylate and pentaerythritol tri(meth)acrylate, and other poly(meth)acrylate compounds, which may be used either alone or in combination. For better compatibility with the hydrogenated elastomer derivative, dimethyloldicyclopentane di(meth)acrylate (tricyclodecanedimethanol diacrylate) is preferably used.

A monofunctional (meth)acrylate may be used in combination with any of the aforementioned multifunctional (meth)acrylates as the poly(meth)acrylate compound (b), as long as the adhesiveness of the seal member of the dye-sensitized solar cell is not impaired.

Examples of the monofunctional (meth)acrylate include isobutyl (meth)acrylate, t-butyl (meth)acrylate, isooctyl (meth)acrylate, lauryl (meth)acrylate, styryl (meth)acrylate, isobonyl (meth)acrylate and cyclohexyl (meth)acrylate, which may be used either alone or in combination.

The proportion of the poly (meth) acrylate compound (b) is preferably 1 to 99 wt%, more preferably 10 to 90 wt%, based on the overall amount of the photopolymerizable composition.

Various photo-radical generators are usable as the photopolymerization initiator (c). Examples of the photopolymerization initiator include 2,2-dimethoxy-1,2-diphenylethan-1-one, 1-hydroxycyclohexyl phenyl ketone, 2-hydroxy-2-methyl-1-phenylpropan-1-one, 2-methyl-1-(4-methylthiophenyl)-2-morpholinopropan-1-one, bis(2,4,6-trimethylbenzoyl)-phenylphosphine oxide, which may be used either alone or in combination.

The proportion of the photopolymerization initiator (c) is preferably 0.1 to 30 wt%, more preferably 0.5 to 20 wt%, based on the overall amount of the photopolymerizable composition. If the proportion is excessively low, the polymerization degree tends to be insufficient. If the proportion is excessively high, the amount of a decomposition residue is increased, and the durability of the seal member 4 tends to be impaired.

In addition to the aforementioned components, other additives such as an antioxidant, a defoaming agent, a surfactant, a colorant, an inorganic filler, an organic filler, various spacers and a solvent may be blended, as required, in the photopolymerizable composition to be used for the seal member 4 according to the use purpose. These additives may be used either alone or in combination.

The photopolymerizable composition thus prepared is irradiated with ultraviolet radiation by means of a UV lamp or the like and, as required, post-cured at a predetermined temperature to form the seal member 4.

### <Production Method of Dye-Sensitized Solar Cell>

Next, a method of producing the dye-sensitized solar cell from the aforementioned materials will be described. The dye-sensitized solar cell shown in Fig. 1 is produced, for example, in the following manner.

First, a working electrode substrate 1' formed with inorganic layers 2', 3' in a double layered structure, an electrically conductive transparent electrode layer 5' and a porous semiconductor layer 7 carrying a sensitizing dye is prepared, and a portion of the inorganic layer 3' provided on the substrate 1' to be brought into contact with a seal member 4 is surface-coated with a silane coupling agent of a (meth)acryloxyalkylsilane. The surface coating treatment is performed, for example, by dissolving 0.01 to 5.0 wt% of the (meth)acryloxyalkylsilane silane coupling agent in an organic solvent such as methanol or ethanol, applying the resulting solution onto the portion of the inorganic layer 3' to be brought into contact with the seal member 4, and heating the resulting substrate to 60°C to 150°C. Thus, a coating film 4' is formed from the applied solution.

On the other hand, a counter electrode substrate 1 formed with inorganic layers 2, 3 in a double layered structure and an electrically conductive transparent electrode layer 5 to be opposed to the working electrode substrate 1' is prepared, and a portion of the inorganic layer 3 provided on the substrate 1 to be brought into contact with the seal member 4 is surface-coated with the (meth)acryloxyalkylsilane silane coupling agent in the same manner as described above. Thus, a coating film 4' is formed.

Then, the photopolymerizable composition preliminarily prepared is applied onto a predetermined portion of at least one of the substrates 1, 1', whereby the seal member 4 is formed in an uncured state. Then, the substrates 1, 1' are bonded to each other by the seal member 4 with the sensitizing-dye-carrying porous semiconductor layer 7 and the electrically conductive transparent electrode layer 5 facing inward, and the seal member 4 is irradiated with ultraviolet radiation emitted by means of an ultraviolet radiation emitting device such as a high pressure mercury lamp, for example, at an irradiation intensity of 0.5 to 10000 mW/cm² for an irradiation period of 0.5 to 600 seconds (preferably in a nitrogen atmosphere) with an about 0.2-mm diameter needle inserted therein to be thereby cured for main sealing.

In turn, an electrolyte solution 6 is injected into a space defined between the substrates 1 and 1' through the needle by a syringe, and then the needle is withdrawn. A hole resulting from the insertion of the needle is sealed with the sealing material in the same manner as described above (end sealing), whereby the seal member 4 is completed. Thus, the dye-sensitized solar cell shown in FIG. 1 is provided.

In the dye-sensitized solar cell shown in Fig. 1, the layer of the electrolyte solution 6, the seal member 4 and the like may each have a proper thickness (generally equal to a distance between the substrates 1 and 1') and a proper width according to the use purpose and application. In general, the seal member 4 preferably has a width of about 1 to about 5 mm and a thickness of 50 to 500 µm.

If the working electrode substrate 1' is transparent, the counter electrode substrate 1 may be opaque or translucent.

In the dye-sensitized solar cell, collector electrodes (not shown) may be provided on at least one of the electrically conductive transparent electrode layers 5, 5' provided on the inner surfaces of the substrates 1, 1' (on the side of the electrolyte solution 6).

The provision of the collector electrodes reduces the electrical resistance of the electrically conductive electrode surface to improve the photo-electric conversion efficiency. Preferred examples of a material for the collector electrodes include electrically conductive metals and metal oxides, carbon materials, and electrically conductive polymers. Examples of the metals include platinum, gold, silver, ruthenium, copper, aluminum, nickel, cobalt, chromium, iron, molybdenum, titanium and tantalum, and alloys of any of these metals. Examples of the carbon materials include graphite, carbon black, glassy carbon, carbon nano-tube and fullerene. It is advantageous to use a transparent or translucent metal oxide such as FTO, ITO, indium oxide or zinc oxide for the collector electrodes, because the amount of light incident on a sensitizing dye layer can be increased.

The collector electrodes are preferably each configured to have a width of 10 to 3000 µm and a thickness of 1 to 100 µm.

The collector electrodes are distributively arranged, for example, in a stripe form, a grid form, a radial form or a network form, preferably in a grid form, on at least one of the surfaces of the electrically conductive electrode layers 5, 5' of the electrode substrates 1, 1'.

### EXAMPLES

Inventive examples will be described in conjunction with comparative examples. It should be understood that the present invention be not limited to these inventive examples.

Prior to implementation of the examples, ingredients for the following components were prepared or synthesized.

### <(Meth)acryloxyalkylsilane Silane Coupling Agent>

As the (meth)acryloxyalkylsilane silane coupling agent, 3-acryloxypropyltrimethoxysilane and 3-methacryloxypropyltrimethoxysilane were prepared.

### <Synthesis of Elastomer Derivatives>

### a. Synthesis of Hydrogenated Elastomer Derivative (a)

First, 15 g (0.01 mol) of a hydrogenated polybutadiene having hydroxyl groups at its opposite molecular terminals as represented by the following general formula (1) (having a number average molecular weight of about 1500, a hydroxyl value of 75 KOH mg/g, an iodine value of 10 I₂ mg/100g and a viscosity of 30 Pa·s/25°C) , 10.2 g (0.05 mol) of norbornene diisocyanate and 20 g of toluene were put in a glass reactor, and heated to 50°C in the stream of nitrogen gas. Then, 0.4 g of an ethyl acetate solution of 5 wt% dibutyltin laurate was added to the resulting mixture, and a reaction was allowed to proceed at 50°C for 6 hours. Thereafter, 0.001 g of hydroquinone and 20.7 g (0.09 mol) of 2-hydroxy-1,3-dimethacryloxypropane (glycerin dimethacrylate) were added to the resulting mixture, and a reaction was allowed to proceed at 60°C for 6 hours. In turn, the reaction product was poured in an excess amount of acetonitrile and stirred to be washed, and then a solid component was separated from a liquid component and dried at a reduced pressure. Thus, an intended hydrogenated elastomer derivative (a) was provided. The absorbance at the characteristic absorption band (about 2260 cm⁻¹) attributable to the isocyanate group in an infrared absorption spectrum of the reaction product (measured by a FT-IR analyzer available under Nicolet IR200 from Thermo Electron KK) was zero. Further, the weight average molecular weight (Mw) of the reaction product measured on the basis of a polystyrene calibration standard by means of a gel permeation chromatograph (GPC available under HLC-8120 from Toso Co., Ltd.) was 6150. 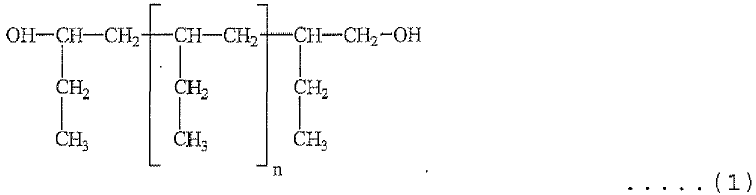 Wherein n is a positive integer.

### b. Synthesis of Hydrogenated Elastomer Derivative (b)

A hydrogenated elastomer derivative (b) was synthesized in substantially the same manner as the hydrogenated elastomer derivative (a), except that 15 g (0.005 mol) of a hydrogenated polybutadiene having hydroxyl groups at its opposite molecular terminals as represented by the above general formula (1) (having a number average molecular weight of about 3000, a hydroxyl value of 30 KOH mg/g, an iodine value of 10 I₂ mg/100g and a viscosity of 80 Pa·s/25°C) was used instead of the hydrogenated polybutadiene (having a number average molecular weight of about 1500) used for the synthesis of the hydrogenated elastomer derivative (a). The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 7500.

### c. Synthesis of Hydrogenated Elastomer Derivative (c)

A hydrogenated elastomer derivative (c) was synthesized in substantially the same manner as the hydrogenated elastomer derivative (a), except that 280 g (0.01 mol) of a hydrogenated polyisoprene having hydroxyl groups at its opposite molecular terminals as represented by the following general formula (2) (having a number average molecular weight of about 28000, a hydroxyl value of 4 KOH mg/g, an iodine value of 40 I₂ mg/100g and a viscosity of 1500 Pa·s/25°C) was used instead of the hydrogenated polybutadiene used for the synthesis of the hydrogenated elastomer derivative (a) . The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 28800. 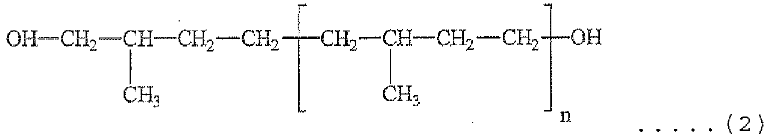 wherein n is a positive integer.

### d. Synthesis of Hydrogenated Elastomer Derivative (d)

First, 15 g (0.01 mol) of the hydrogenated polybutadiene having a number average molecular weight of about 1500 for the synthesis of the hydrogenated elastomer derivative (a), 7 g (0.03 mol) of 1,1-bis(acryloyloxymethyl)ethyl isocyanate as the (meth)acryloyl-containing isocyanate compound and 0.3 g of an ethyl acetate solution of 5 wt% dibutyltin laurate were blended, and a reaction was allowed to proceed at 50°C for 6 hours in the stream of nitrogen gas. In turn, the reaction product was poured in an excess amount of acetonitrile and stirred to be washed, and then a solid component was separated from a liquid component and dried at a reduced pressure. Thus, an intended hydrogenated elastomer derivative (d) was provided. The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 5020.

### e. Synthesis of Hydrogenated Elastomer Derivative (e)

A hydrogenated elastomer derivative (e) was synthesized in substantially the same manner as the hydrogenated elastomer derivative (d), except that 30 g (0.01 mol) of the hydrogenated polybutadiene having a number average molecular weight of about 3000 for the synthesis of the hydrogenated elastomer derivative (b) was used instead of the hydrogenated polybutadiene (having a number average molecular weight of about 1500) used for the synthesis of the hydrogenated elastomer derivative (d) and 15 g of toluene was used. The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 7290. f. Synthesis of Hydrogenated Elastomer Derivative (f)

A hydrogenated elastomer derivative (f) was synthesized in substantially the same manner as the hydrogenated elastomer derivative (d), except that 280 g (0.01 mol) of a hydrogenated polyisoprene having hydroxyl groups at its opposite molecular terminals as represented by the above general formula (2) (having a number average molecular weight of about 28000, a hydroxyl value of 4 KOH mg/g, an iodine value of 40 I₂ mg/100g and a viscosity of 1500 Pa·s/25°C) was used instead of the hydrogenated polybutadiene (having a number average molecular weight of about 1500) used for the synthesis of the hydrogenated elastomer derivative (d) and 15 g of toluene was used. The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 7290. g. Synthesis of Unsaturated Elastomer Derivative (g)

An unsaturated elastomer derivative (g) was synthesized in substantially the same manner as the hydrogenated elastomer derivative (a), except that 15 g (0.01 mol) of an unsaturated polybutadiene having hydroxyl groups at its opposite molecular terminals as represented by the following general formula (3) (having a number average molecular weight of about 1500, a hydroxyl value of 70 KOH mg/g and a viscosity of 90 Pa·s/25°C) was used instead of the hydrogenated polybutadiene (having a number average molecular weight of about 1500) used for the synthesis of the hydrogenated elastomer derivative (a). The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 5900. 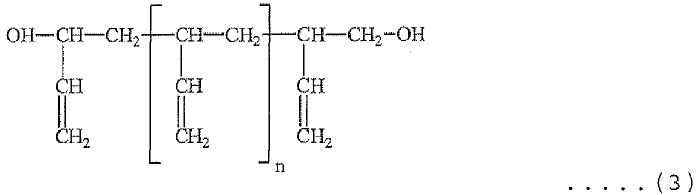 wherein n is a positive integer.

### h. Synthesis of Unsaturated Elastomer Derivative (h)

An unsaturated elastomer derivative (h) was synthesized in substantially the same manner as the hydrogenated elastomer derivative (d), except that 15 g (0.01 mol) of the unsaturated polybutadiene having hydroxyl groups at its opposite molecular terminals as represented by the above general formula (3) for the synthesis of the unsaturated elastomer derivative (g) was used instead of the hydrogenated polybutadiene used for the synthesis of the hydrogenated elastomer derivative (d). The absorbance at the characteristic absorption band (about 2260 cm⁻¹) attributable to the isocyanate group in an infrared absorption spectrum (FT-IR) of the reaction product was zero. Further, the weight average molecular weight (Mw) of the reaction product measured on the basis of a polystyrene calibration standard by means of a gel permeation chromatograph (GPC) was 4900.

### <Poly(meth)acrylate Compound>

As the poly(meth)acrylate compound, dimethyloldicyclopentane diacrylate (tricyclodecanedimethanol diacrylate) and 1,6-hexanediol diacrylate were prepared.

### <Photopolymerization Initiator>

As the photopolymerization initiator, a photo-radical polymerization initiator IRGACURE 651 available from Chiba Specialty Chemicals Co., Ltd. was prepared.

### <Organically Treated Phyllosilicate>

### (1) Organically Treated Swellable Mica

Interlaminar Na ions of a mica were replaced with a tetraalkyl ammonium compound. Thus, an organically treated swellable mica was prepared which had an average length of 5 µm, a thickness of 0.1 to 0.5 µm, an aspect ratio of 20 to 30 and an absolute specific gravity of 2.5.

### (2) Organically Treated Synthetic Smectite

Exchangeable interlaminar cations (Na⁺, Mg²⁺, Li⁺ and the like) of a smectite were replaced with a tetraalkyl ammonium compound. Thus, an organically treated synthetic smectite was prepared which had a length of 0.1 to 2 µm, a thickness of 0.001 to 0.025 µm, an aspect ratio of 80 to 1000 and an absolute specific gravity of 2.7.

### <Organically Treated Insulative Spherical Inorganic Fillers>

### (1) Organically Treated Spherical Silica α

First, 20 g of a spherical synthetic silica having a surface hydroxyl group concentration of 0.002 mmol/g, a specific surface area of 28.6 m²/g an average particle diameter of 0.1 µm and a maximum particle diameter of 2 µm, 12.91 g of hexamethyldisilazane and 100 g of hexane were put in a glass flask provided with a cooling water pipe, and the resulting mixture was refluxed at about the boiling point of hexane (65°C to 69°C) for two hours. Thereafter, the resulting spherical synthetic silica was filtered out with the use of a paper filter, and dried at a reduced pressure at 40°C for 6 hours. Thus, an organically treated spherical silica α was provided. In the infrared absorption spectrum (FT-IR) of the organically treated spherical silica α, absorption was observed at the characteristic absorption band (about 2960 cm⁻¹) attributable to the methyl group. (2) Organically Treated Spherical Silica β

First, 20 g of a spherical synthetic silica having a surface hydroxyl group concentration of 0.002 mmol/g, a specific surface area of 28.6 m²/g an average particle diameter of 0.1 µm and a maximum particle diameter of 2 µm, 2.7 g of 3-acryloxypropyltrimethoxysilane, 100 g of methanol and 0.054 g of acetic acid were put in a glass flask provided with a cooling water pipe, and the resulting mixture was stirred at about a room temperature (22°C to 26°C) for 12 hours. Thereafter, the resulting spherical synthetic silica was filtered out with the use of a paper filter, and dried at a reduced pressure at 60°C for 12 hours in a shade. Thus, an organically treated spherical silica β was provided. In the infrared absorption spectrum (FT-IR) of the organically treated spherical silica β, absorption was observed at the characteristic absorption bands (about 1620 cm⁻¹ and about 1720 cm⁻¹) attributable to the acryloyl group.

### (3) Organically Treated Spherical Silica γ

First, 20 g of a spherical synthetic silica having a surface hydroxyl group concentration of 0.002 mmol/g, a specific surface area of 28.6 m²/g, an average particle diameter of 0.1 µm and a maximum particle diameter of 2 µm, 22.34 g of 2-isocyanatoethyl methacrylate, 100 g of toluene and 2.3 g of an ethyl acetate solution of 5 wt% dibutyltin laurate were put in a glass flask provided with a cooling water pipe, and a reaction was allowed to proceed at 50°C for 6 hours in a shade. Thereafter, the resulting spherical synthetic silica was filtered out with the use of a paper filter, and dried at a reduced pressure at 60°C for 12 hours in a shade. Thus, an organically treated spherical silica γ was provided. In the infrared absorption spectrum (FT-IR) of the organically treated spherical silica, the absorption at the characteristic absorption band (about 2260 cm⁻¹) attributable to the isocyanate group was zero, and absorption was observed at the characteristic absorption bands (about 1620 cm⁻¹ and about 1720 cm⁻¹) attributable to the acryloyl group.

### <Example 1>

The following components were prepared by the following methods (I) to (II), and a dye-sensitized solar cell was assembled in the following manner (III). (I) Preparation of Working Electrode Substrate and Counter Electrode Substrate

### (I-a) Preparation of Working Electrode Substrate Surface-Coated with Specific Silane Coupling Agent

A SiOCN layer was formed on a resin substrate (made of a polyethylene naphthalate (PEN) and having a size of 76 mm x 52 mm x 125 µm (thickness)) by a plasma assist evaporation method, and then a surface of the SiOCN layer was oxidized to form a SiO₂ layer, whereby a double layered structure was provided. More specifically, an about 250-nm thick SiOCN layer and an about 40-nm thick SiO₂ layer were provided in the form of an inorganic double layered structure. After an ITO electrically conductive transparent electrode layer was formed on a surface of the inorganic layer (SiO₂ layer), a porous titanium oxide semiconductor layer was formed on an upper surface of the ITO electrically conductive transparent layer with L-4,4'-dicarboxy-2,2'-bipyridyl (N3 dye) adsorbed and carried thereon. Thus, a working electrode substrate formed with the porous semiconductor layer on which the sensitizing dye was adsorbed and carried was prepared. Then, a methanol solution of 1 wt% 3-acryloxypropyltrimethoxysilane preliminarily prepared was applied onto a portion of the inorganic layer (SiO₂ layer) provided on the working electrode substrate to be brought into contact with a seal member, and dried at 100°C for 10 minutes. Thus, the working electrode substrate was surface-coated with the silane coupling agent (or formed with a coating film).

### (I-b) Preparation of Counter Electrode Substrate Surface-Coated with Specific Silane Coupling Agent

A resin substrate (made of a polyethylene naphthalate (PEN) and having a size of 76 mm x 52 mm x 125 µm (thickness)) formed with an inorganic double layered structure was prepared as a counter electrode substrate to be opposed to the working electrode substrate. As in the preparation of the working electrode substrate, a SiOCN layer was formed on the resin substrate by a plasma assist evaporation method, and then a surface of the SiOCN layer was oxidized to form a SiO₂ layer, whereby the inorganic double layered structure was provided. More specifically, an about 250-nm thick SiOCN layer and an about 40-nm thick SiO₂ layer were provided as the inorganic double layered structure. Subsequently, an ITO electrically conductive transparent electrode layer was formed on the inorganic layer (SiO₂ layer). Thus, the counter electrode substrate was completed. Then, a methanol solution of 1 wt% 3-acryloxypropyltrimethoxysilane preliminarily prepared was applied onto a portion of the inorganic layer (SiO₂ layer) provided on the counter electrode substrate to be brought into contact with the seal member, and dried at 100°C for 10 minutes in the same manner as described above. Thus, the counter electrode substrate was surface-coated with the silane coupling agent (or formed with a coating film).

### (II) Preparation of Specific Photopolymerizable Composition for Seal Member

A photopolymerizable composition was prepared by blending 3g of the hydrogenated elastomer derivative (a), 7g of dimethyloldicyclopentane diacrylate (tricyclodecanedimethanol diacrylate) and 0.5 g of the photo-radical polymerization initiator.

### (III) Assembling of Dye-Sensitized Solar Cell

A main sealing operation was performed by applying the photopolymerizable composition as a sealing material to a width of 5 mm and a thickness of 50 µm onto the portion of the inorganic layer (SiO₂ layer) provided on the working electrode substrate to be brought into contact with the seal member by means of a dispenser, bonding the working electrode substrate to the other substrate (counter electrode substrate) with surfaces of the electrically conductive transparent electrode layers facing inward and opposed to each other and with a 0. 2-mm diameter needle inserted in the seal material, and irradiating the applied photopolymerizable composition with ultraviolet radiation (at 3000 mJ/cm²) from the side of the working electrode substrate in a nitrogen stream. Then, an electrolyte solution (a 3-methoxypropionitrile solution containing 0.05 mol/L of iodine and 0.5 mol/L of lithium iodide) was injected into a space defined between the substrates through the needle by a syringe, and then the needle was withdrawn. An end sealing operation was performed by sealing a hole resulting from the insertion of the needle with the sealing material, and irradiating the sealing material with ultraviolet radiation (at 3000 mJ/cm²) in a nitrogen stream in the same manner as described above. Thus, the intended dye-sensitized solar cell was assembled which included the polymer resin substrates (plastic films) as shown in FIG. 1.

### <Example 2>

A dye-sensitized solar cell was assembled in substantially the same manner as in Example 1, except that a methanol solution of 1 wt% 3-methacryloxypropyltrimethoxysilane was applied as the silane coupling agent instead of the methanol solution of 1 wt% 3-acryloxypropyltrimethoxysilane onto the portion of the inorganic layer (SiO₂ layer) provided on the working electrode substrate to be brought into contact with the seal member.

### <Example 3>

A dye-sensitized solar cell was assembled in substantially the same manner as in Example 1, except that a photopolymerizable composition prepared by blending 7 g of the hydrogenated elastomer derivative (a), 3 g of dimethyloldicyclopentane diacrylate (tricyclodecanedimethanol diacrylate) and 0.5 g of the photo-radical polymerization initiator was used instead of the photopolymerizable composition of Example 1.

### <Example 4>

A dye-sensitized solar cell was assembled in substantially the same manner as in Example 1, except that the hydrogenated elastomer derivative (b) was used instead of the hydrogenated elastomer derivative (a) for preparation of the photopolymerizable composition (A).

### <Example 5>

A dye-sensitized solar cell was assembled in substantially the same manner as in Example 1, except that a photopolymerizable composition prepared by blending 5 g of the hydrogenated elastomer derivative (a), 3 g of 1,6-hexanediol diacrylate and 0.5 g of the photo-radical polymerization initiator was used instead of the photopolymerizable composition of Example 1.

### <Example 6>

A dye-sensitized solar cell was assembled in substantially the same manner as in Example 1, except that the hydrogenated elastomer derivative (c) was used instead of the hydrogenated elastomer derivative (a) for preparation of the photopolymerizable composition.

### <Example 7>

A dye-sensitized solar cell was assembled in substantially the same manner as in Example 1, except that the hydrogenated elastomer derivative (d) was used instead of the hydrogenated elastomer derivative (a) for preparation of the photopolymerizable composition.

### <Example 8>

A dye-sensitized solar cell was assembled in substantially the same manner as in Example 7, except that a methanol solution of 1 wt% 3-methacryloxypropyltrimethoxysilane was applied instead of the silane coupling agent of Example 7 onto the portion of the inorganic layer (SiO₂ layer) provided on the working electrode substrate to be brought into contact with the seal member.

### <Example 9>

A dye-sensitized solar cell was assembled in substantially the same manner as in Example 7, except that a photopolymerizable composition prepared by blending 7 g of the hydrogenated elastomer derivative (d), 3 g of dimethyloldicyclopentane diacrylate (tricyclodecanedimethanol diacrylate) and 0.5 g of the photo-radical polymerization initiator was used instead of the photopolymerizable composition of Example 7.

### <Example 10>

A dye-sensitized solar cell was assembled in substantially the same manner as in Example 7, except that the hydrogenated elastomer derivative (e) was used instead of the hydrogenated elastomer derivative (d) for preparation of the photopolymerizable composition (A).

### <Example 11>

A dye-sensitized solar cell was assembled in substantially the same manner as in Example 7, except that a photopolymerizable composition prepared by blending 7 g of the hydrogenated elastomer derivative (d), 3 g of 1,6-hexanediol diacrylate and 0.5 g of the photo-radical polymerization initiator was used instead of the photopolymerizable composition of Example 7.

### <Example 12>

A dye-sensitized solar cell was assembled in substantially the same manner as in Example 7, except that the hydrogenated elastomer derivative (f) was used instead of the hydrogenated elastomer derivative (d) for preparation of the photopolymerizable composition.

### <Example 13>

A dye-sensitized solar cell was assembled in substantially the same manner as in Example 1, except that a photopolymerizable composition prepared by adding 1 g of the organically treated swellable mice to the photopolymerizable composition of Example 1 and milling the resulting mixture through a three-roll mill (having a roll gap of 0.1 µm) ten times was used instead of the photopolymerizable composition of Example 1.

### <Example 14>

A dye-sensitized solar cell was assembled in substantially the same manner as in Example 1, except that a photopolymerizable composition prepared by adding 15 g of the organically treated synthetic smectite to the photopolymerizable composition of Example 1 and milling the resulting mixture through a three-roll mill (having a roll gap of 0.1 µm) ten times was used instead of the photopolymerizable composition of Example 1.

### <Example 15>

A dye-sensitized solar cell was assembled in substantially the same manner as in Example 1, except that a photopolymerizable composition prepared by adding 10 g of the organically treated spherical silica α to the photopolymerizable composition of Example 1 and milling the resulting mixture through a three-roll mill (having a roll gap of 0.1 µm) ten times was used instead of the photopolymerizable composition of Example 1.

### <Example 16>

A dye-sensitized solar cell was assembled in substantially the same manner as in Example 1, except that a photopolymerizable composition prepared by adding 10 g of the organically treated spherical silica β to the photopolymerizable composition of Example 1 and milling the resulting mixture through a three-roll mill (having a roll gap of 0.1 µm) ten times was used instead of the photopolymerizable composition of

### Example 1.

### <Example 17>

A dye-sensitized solar cell was assembled in substantially the same manner as in Example 1, except that a photopolymerizable composition prepared by adding 10 g of the organically treated spherical silica γ to the photopolymerizable composition of Example 1 and milling the resulting mixture through a three-roll mill (having a roll gap of 0.1 µm) ten times was used instead of the photopolymerizable composition of

### Example 1.

### <Comparative Example 1>

A dye-sensitized solar cell was assembled in substantially the same manner as in Example 1, except that the portions of the inorganic layers (SiO₂ layers) provided on the respective substrates to be brought into contact with the seal member were not subjected to any surface coating treatment.

### <Comparative Example 2>

A dye-sensitized solar cell was assembled in substantially the same manner as in Example 1, except that a methanol solution of 1 wt% 3-glycidoxypropyltrimethoxysilane was applied instead of the silane coupling agent of Example 1 onto the portions of the inorganic layers (SiO₂ layers) provided on the respective substrates to be brought into contact with the seal member.

### <Comparative Example 3>

A dye-sensitized solar cell was assembled in substantially the same manner as in Example 1, except that the unsaturated elastomer derivative (g) was used instead of the hydrogenated elastomer derivative (a) for preparation of the photopolymerizable composition.

### <Comparative Example 4>

A dye-sensitized solar cell was assembled in substantially the same manner as in Example 7, except that the portions of the inorganic layers (SiO₂ layers) provided on the respective substrates to be brought into contact with the seal member were not subjected to any surface coating treatment.

### <Comparative Example 5>

A dye-sensitized solar cell was assembled in substantially the same manner as in Example 7, except that a methanol solution of 1 wt% 3-glycidoxypropyltrimethoxysilane was applied instead of the silane coupling agent of Example 7 onto the portions of the inorganic layers (SiO₂ layers) provided on the respective substrates to be brought into contact with the seal member.

### <Comparative Example 6>

A dye-sensitized solar cell was assembled in substantially the same manner as in Example 7, except that the unsaturated elastomer derivative (h) was used instead of the hydrogenated elastomer derivative (d) for preparation of the photopolymerizable composition.

The dye-sensitized solar cells thus obtained were allowed to stand in a thermostatic chamber at 80°C at 85 %RH (relative humidity) for 500 hours (about 21 days) for test. Then, endurance tests for liquid leakage and swelling were performed by the following methods. The results of the tests are shown below in Table 1.

### <Liquid Leakage>

An electrolyte solution filling area as seen from an upper side of the dye-sensitized solar cell was measured immediately after the assembling and after the test. An area percentage of the filling area measured after the test with respect to the filling area measured immediately after the assembling was determined, which was defined as an index of liquid leakage. Without the liquid leakage, the area percentage is 100%. The degree of the liquid leakage is increased as the area percentage decreases. This measurement is based on the fact that, if the electrolyte solution leaks, a space is correspondingly created in which the electrolyte solution is not present, and the electrolyte solution filling area after the test is smaller than that before the test.

### <Swelling>

If the electrolyte solution (containing iodine) permeates into the seal member in the assembled dye-sensitized solar cell, colorization with the iodine occurs transversely of the seal member (from the inside to the outside parallel to the substrates). Therefore, the width of the colorization with the iodine was measured, which was defined as an index of the swelling of the seal member with the electrolyte solution (based on the fact that the swelling occurs as a result of the permeation of the electrolyte solution). The swelling is less liable to occur when the width of the coloration is smaller. Since the width of the seal member is 5 mm at the maximum, the width of the coloration with the iodine is also 5 mm at the maximum.

**Table 1**

| | Liquid leakage (area: %) | Swelling (Coloration width: mm) |
|---|---|---|
| Example 1 | 100 | 0.1 |
| Example 2 | 98 | 0.2 |
| Example 3 | 97 | 0.8 |
| Example 4 | 96 | 1.0 |
| Example 5 | 95 | 0.5 |
| Example 6 | 98 | 0.1 |
| Example 7 | 100 | ≤0.05 |
| Example 8 | 100 | ≤0.05 |
| Example 9 | 97 | 1.8 |
| Example 10 | 99 | ≤0.05 |
| Example 11 | 95 | 1.0 |
| Example 12 | 98 | 0.1 |
| Example 13 | 100 | ≤0.05 |
| Example 14 | 99 | ≤0.05 |
| Example 15 | 100 | ≤0.05 |
| Example 16 | 99 | 0.1 |
| Example 17 | 98 | 0.1 |
| Comparative Example 1 | 0 | 5.0 (overall width) |
| Comparative Example 2 | 0 | 5.0 (overall width) |
| Comparative Example 3 | 15 | 5.0 (overall width) |
| Comparative Example 4 | 0 | 5.0 (overall width) |
| Comparative Example 5 | 0 | 5.0 (overall width) |
| Comparative Example 6 | 10 | 5.0 (overall width) |

The results of the measurement of the liquid leakage indicate that the products of the inventive examples were substantially free from the leakage of the electrolyte solution with a filling area percentage of 95% or greater. As a result of the measurement of the swelling, the product of Example 9 had a coloration width of 1.8 mm, but was practically acceptable. The products of the other inventive examples had little swelling with a coloration width of 1.0 mm or less. Therefore, the dye-sensitized solar cells of the inventive examples were excellent in sealing property.

On the other hand, the products of the comparative examples apparently suffered from the leakage of the electrolyte solution with a filling area percentage of 0 to 15 % as a result of the measurement of the liquid leakage. As a result of the measurement of the swelling, the products of the comparative examples disadvantageously suffered from significant swelling with a coloration width of 5.0 mm, which was the maximum coloration width (equal to the overall width).

In each of the products of the inventive examples, the SiOCN layers (the inorganic layers 2, 2' in FIG. 1) of the inorganic double layered structures provided on the respective substrates each functioned as a gas barrier film, and the SiO₂ layers (the inorganic layers 3, 3' in FIG. 1) of the inorganic double layered structures were highly reactive with the silane coupling agent. In addition, the substrates, the seal member and the like were excellent in electrolyte solution resistance, adhesiveness and durability. Therefore, the products of the inventive examples were excellent in liquid leakage resistance, swelling resistance and durability. Thus, the dye-sensitized solar cells of the inventive examples each including the polymer resin substrates as described above were highly excellent and capable of enduring long-term storage and use.

In the inventive dye-sensitized solar cell, the seal member is composed of the material cured by photopolymerizing the specific photopolymerizable composition, which obviates the need for thermal curing. Therefore, the dye-sensitized solar cell is free from the separation of the seal member which may otherwise occur due to the evaporation of the electrolyte solution caused by the heating, and free from the swelling and the degradation with the electrolyte solution during prolonged sealing use. In addition, the synergetic effect of the aforementioned specific silane coupling agent on the polymer resin substrates ensures higher adhesiveness and higher durability. Therefore, the present invention is widely applicable to dye-sensitized solar cells of a polymer resin type which particularly require durability, and ensures higher reliability.

Although specific forms of embodiments of the instant invention have been described above and illustrated in the accompanying drawings in order to be more clearly understood, the above description is made by way of example and not as a limitation to the scope of the instant invention. It is contemplated that various modifications apparent to one of ordinary skill in the art could be made without departing from the scope of the invention.

## Claims

1. A dye-sensitized solar cell, comprising:
a pair of substrates including a counter electrode substrate provided with a counter electrode layer and a working electrode substrate provided with an electrically conductive transparent working electrode layer, the substrates being opposed to each other and spaced a predetermined distance from each other with the counter electrode layer and the working electrode layer facing inward,
a seal member disposed along peripheries of inner surfaces of the substrates to seal a space defined between the substrates; and
an electrolyte solution filled in the sealed space;
wherein the substrates are each made of a polymer resin material;
wherein inorganic layers are provided between the counter electrode substrate and the counter electrode layer and between the working electrode substrate and the working electrode layer;
wherein the seal member is composed of a material cured by photopolymerizing a photopolymerizable composition comprising a hydrogenated elastomer derivative having at least one (meth)acryloyl group at at least one of its opposite molecular terminals; and
wherein the inorganic layers each have a portion coated with a silane coupling agent of a (meth)acryloxyalkylsilane in contact with the seal member.

2. The dye-sensitized solar cell according to claim 1, wherein the inorganic layers are transparent inorganic layers each made of at least one of an oxide, a nitride, an oxynitride, an oxycarbide, a nitrocarbide and an oxynitrocarbide of at least one element selected from the group consisting of Si, Al, In, Sn, Zn, Ti, Nb, Ce and Zr.

3. The dye-sensitized solar cell according to claim 1 or 2, wherein the inorganic layers each include at least two inorganic layers provided in a layered structure.

4. The dye-sensitized solar cell according to any one of claims 1 to 3, wherein the inorganic layers each include at least one inorganic layer selected from the group consisting of a silicon oxide layer, a silicon oxynitride layer, a silicon oxycarbide layer, a silicon oxycarbonitride layer and a silicon nitride layer.

5. The dye-sensitized solar cell according to any one of claims 1 to 4, wherein the counter electrode layer includes one of an electrically conductive transparent layer and an electrically conductive layer made of at least one selected from the group consisting of platinum, carbon, gold and an electrically conductive polymer.

6. The dye-sensitized solar cell according to any one of claims 1 to 5, wherein the photopolymerizable composition comprises a phyllosilicate.

7. The dye-sensitized solar cell according to any one of claims 1 to 6, wherein the photopolymerizable composition comprises an insulative spherical inorganic filler.

8. The dye-sensitized solar cell according to any one of claims 1 to 7, wherein the silane coupling agent of the (meth)acryloxyalkylsilane is 3-(meth)acryloxypropyltrimethoxysilane.

9. The dye-sensitized solar cell according to any one of claims 1 to 8, wherein the hydrogenated elastomer derivative of the photopolymerizable composition comprises a hydrogenated polybutadiene in its main chain.

10. The dye-sensitized solar cell according to any one of claims 1 to 8, wherein the hydrogenated elastomer derivative of the photopolymerizable composition comprises a hydrogenated polyisoprene in its main chain.

11. The dye-sensitized solar cell according to any one of claims 1 to 9, wherein the hydrogenated elastomer derivative of the photopolymerizable composition is a hydrogenated polybutadiene derivative obtained through a reaction between a hydrogenated polybutadiene polyol and a hydroxy(meth)acrylate compound by using a polyisocyanate as a linking group.

12. The dye-sensitized solar cell according to any one of claims 1 to 8 and 10, wherein the hydrogenated elastomer derivative of the photopolymerizable composition is a hydrogenated polyisoprene derivative obtained through a reaction between a hydrogenated polyisoprene polyol and a hydroxy(meth)acrylate compound by using a polyisocyanate as a linking group.

13. The dye-sensitized solar cell according to any one of claims 1 to 9, wherein the hydrogenated elastomer derivative of the photopolymerizable composition is a hydrogenated polybutadiene derivative obtained through a reaction between a hydrogenated polybutadiene polyol and a (meth)acryloyl-containing isocyanate compound.

14. The dye-sensitized solar cell according to any one of claims 1 to 8 and 10, wherein the hydrogenated elastomer derivative of the photopolymerizable composition is a hydrogenated polyisoprene derivative obtained through a reaction between a hydrogenated polyisoprene polyol and a (meth)acryloyl-containing isocyanate compound.

15. A dye-sensitized solar cell seal member to be disposed along peripheries of inner surfaces of paired substrates disposed in opposed relation in a dye-sensitized solar cell as recited in any one of claims 1 to14, the seal member comprising a material cured by photopolymerizing a photopolymerizable composition essentially comprising a hydrogenated elastomer derivative having at least one (meth)acryloyl group at at least one of its opposite molecular terminals.

16. Process for manufacturing a dye-sensitized solar cell according to anyone of Claims 1-14, comprising the steps of
providing a working electrode substrate with at least one inorganic layer and an electrically conductive transparent working electrode layer in this order, providing a counter electrode substrate with at least one inorganic layer and a counter-electrode layer in this order;
coating a portion of the two inorganic layers on the first and second substrate with a silane coupling agent of a (meth)acryloxyalkylsilane;
applying an uncured form of a seal member material onto the silane coupling agent-coated portion of at least one of the inorganic layers; wherein the seal member material consists of a photopolymerizable composition comprising a hydrogenated elastomer derivative having at least one (meth)acryloyl group at at least one of its opposite molecular terminals;
bonding the substrates to each other via the uncured seal member material such that the substrate are opposed to each other at a predetermined distance, that the counter electrode layer and the working electrode layer face inwards, and such that seal member material forms a seal member that is disposed along the peripheries of inner surfaces of the substrates to seal a space defined between the substrates;
curing the seal member material by irradiation; and Injecting an electrolyte solution into said space defined by the inner surfaces of the coated substrates and the seal member.
